# EUROPEAN PATENT SPECIFICATION

(11) **EP 3 564 472 B1**
(45) Date of publication and mention of the grant of the patent: **27.01.2021**
(21) Application number: 19169937.0
(22) Date of filing: 17.04.2019
(51) Int. Cl.: E05F 15/44, H01H 3/14, H01H 3/16

(54) **PINCH DETECTION SWITCH**
EINKLEMMDETEKTIONSSCHALTER
COMMUTATEUR DE DÉTECTION DE PINCEMENT

(30) Priority: 02.05.2018 JP 2018088826
(43) Date of publication of application: 06.11.2019
(73) Proprietor: Hitachi Metals, Ltd., Tokyo 108-8224 (JP)
(72) Inventor: Kawase, Kenji, Tokyo 108-8224 (JP); Suzuki, Shuichi, Tokyo 108-8224 (JP)
(74) Representative: Betten & Resch

(56) References cited:
- EP-A1- 1 526 241
- DE-A1-102006 015 687
- DE-B- 1 060 455
- GB-A- 2 195 207
- JP-A- 2014 216 300
- US-A1- 2002 104 373

## Description

### Cross-Reference to Related Applications

The present application is based on Japanese patent application No. 2018-088826 filed on May 2, 2018.

### BACKGROUND OF THE INVENTION

### 1. FIELD OF THE INVENTION

The present invention relates to a pinch detection switch for detecting pinching in a movable body such as a door closing and open portion in a vehicle such as an automobile.

### 2. DESCRIPTION OF THE RELATED ART

Conventionally, a pinch detection switch for detecting pinching is disposed in an end portion on a forward side in a moving direction of a movable body such as a slidable door of an automobile which can pinch a human body or baggage thereof (see e.g. JP-A-2014-2163 00).

A pinch detection switch (so-called "cord switch") described in JP-A-2014-216300 includes a cord switch main body, and a member to be attached, which functions as a bracket for fixing the cord switch main body to the slidable door. The cord switch body comprises a hollow tubular member having elasticity and insulation properties, a plurality of conductor wires spaced apart from each other and opposed to an inner surface of the tubular member, and a cord cover, which covers the tubular member.

The cord cover has a tubular shape in which a hollow portion which receives the tubular member is formed in a center portion, and a tubular member holding a conductor wire is inserted in that hollow portion. When the cord cover collides with a pinched object (for example, a human body) to be detected during forward movement in the moving direction (closing direction) of the slide door, the conductor wires held by the tubular member come into contact with each other due to the pressure caused by the collision, so the electric resistance between the conductor wires varies. The occurrence of pinching can then be detected by this change in electrical resistance.

### SUMMARY OF THE INVENTION

In the pinch detection switch described in JP-A-2014-216300, at the time of assembly, it is necessary to insert the tubular member into a hollow portion of the cord cover over substantially the entire length of the cord cover. This work is difficult. Further, when the cord cover is sufficiently large as compared with the tubular member and no large frictional force is caused between the inner surface of the hollow portion and the outer circumferential surface of the tubular member, it is possible to easily insert the tubular member into the hollow portion, but, in this case, the position of the tubular member within the hollow portion becomes unstable, and it may be impossible to detect an appropriate pinching.
A pinch detection switch according to the preamble of claim 1 is disclosed in GB 2 195 207 A. Furthermore, another pinch detection switch according to the pramble of claim 1, however, with only conducting wire wire rather than a plurality of conducting wires as the pressure sensing member, is disclosed in EP 1 526 241 A1.

It is an object of the present invention to provide a pinch detection switch, which is easy to assemble, and capable of properly performing pinch detection.

In order to solve the above-described problems, the present invention provides a pinch detection switch according to claim 1. The dependent calims define embodiments of the invention.

### Points of the invention

The pinch detection switch according to the present invention is easy to assemble, and makes it possible to properly perform pinch detection.

### BRIEF DESCRIPTION OF THE DRAWINGS

**FIG. 1** is a configuration diagram showing a vehicle that is one example to which a pinch detection switch according to an embodiment of the present invention is applied;
**FIG 2A** is a cross sectional view showing the pinch detection switch at a cross section at right angles to a longitudinal direction;
**FIG 2B** is a perspective view showing the pinch detection switch;
**FIG 3** is a perspective view showing one linear pressure sensing member 31;
**FIG 4** is a circuit diagram showing one example of an electric circuit for detecting pinching in a slide door with the linear pressure sensing member together with a control device and an electric motor;
**FIG 5** is an explanatory view showing a state when an object to be detected comes into contact with a cover member of the pinch detection switch along a moving direction of the slidable door;
**FIG 6** is an explanatory view showing a state when the object to be detected comes into contact with the cover member along a direction tilted with respect to the moving direction of the slidable door;
**FIG 7** is an explanatory view showing an assembling step of inserting a pressure sensing structure into a hollow portion of the cover member at the time of producing the pinch detection switch;
**FIG 8** is a cross-sectional view showing a pinch detection switch according to a first modified embodiment;
**FIG 9** is a cross-sectional view showing a pinch detection switch according to a second modified embodiment; and
**FIG 10** is a cross-sectional view showing a pinch detection switch according to a third modification.

### DETAILED DESCRIPTION OF THE PREFERRED EMBODIMENTS

### [Embodiment]

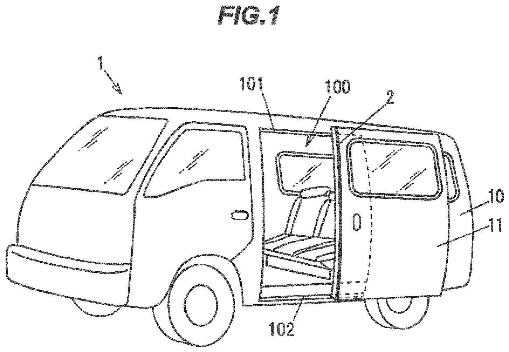

**FIG 1** is a schematic diagram showing a vehicle as one example to which a pinch detection switch (also referred to as a pinch detection sensor, a door sensor, a door switch) according to an embodiment of the present invention is applied.

This vehicle **1** has a vehicle body **10** and a slidable door **11** that can open and close a door open portion **100** formed in the vehicle body **10.** The slidable door **11** is guided to an upper guide rail **101** and a lower guide rail **102** and is moved in the front and rear directions of the vehicle **1** by the driving force of an electric motor. When the slidable door **11** is moved to the front of the vehicle **1,** the door open portion **100** is closed. The slidable door **11** is an embodiment of a movable body of the present invention. Further, in the following description, the front direction of the vehicle, which is the closing direction, will be described as the forward direction of the moving directions.

In the end portion on the forward side in the moving direction of the slide door **11,** a pinching detection switch **2** is extended and disposed along a vehicle vertical direction. When the pinch detection switch **2** comes in contact with a human body or baggage pinched to be detected when the slidable door **11** is closed, that contact is detected by a control device, and the control device stops or reverses the electric motor. This makes it possible to prevent the object to be detected from being strongly pinched between the slidable door **11** and the vehicle body **10.**

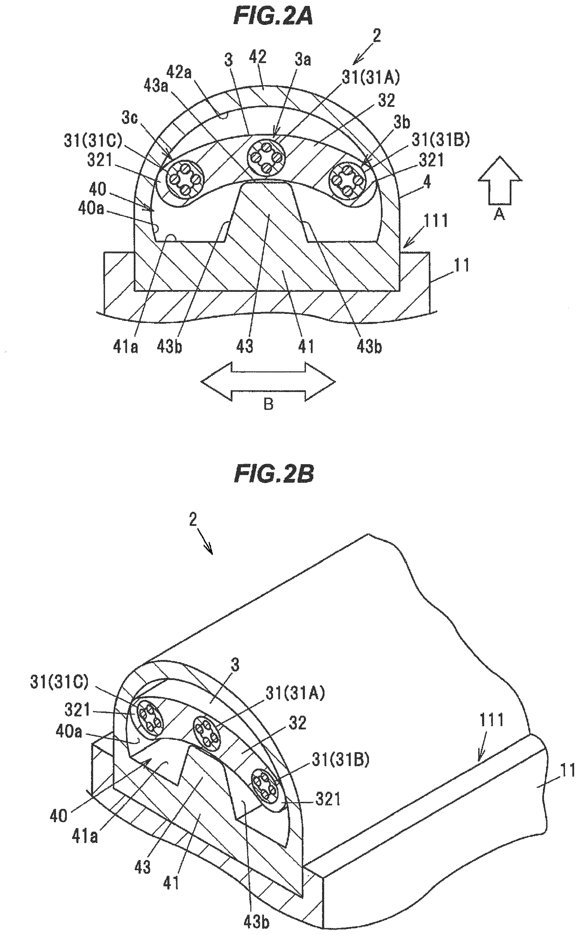

**FIG. 2A** is a cross-sectional view showing the pinch detection switch **2** in a cross section at right angles to the longitudinal direction. **FIG. 2B** is a perspective view showing the pinch detection switch **2.** In **FIG. 2A****,** the vertical direction in the figure corresponds to the moving direction of the slidable door **11,** and the forward direction in the moving direction of the slidable door **11** is indicated by an arrow A. Hereinafter, the forward direction in the moving direction of the slidable door **11** is simply referred to as the moving forward direction.

The pinch detection switch **2** includes a pressure sensing structure **3** having a linear pressure sensing member **31,** a coating member **32** covering the linear pressure sensing member **31** and a tubular cover member **4** having a hollow portion **40** for receiving the pressure sensitive structure **3.** In the present embodiment, the pressure sensing structure **3** is in the shape of a belt (a circular arc in **FIG. 2A**), and is disposed substantially over the entire end portion on the forward side in the moving direction of the slidable door **11.** Further, in the present embodiment, the pressure sensing structure **3** has three of the linear pressure sensing members **31,** and these three linear pressure sensing members **31** are arranged parallel to each other in the longitudinal direction of the pinch detection switch **2** (in the extending direction of the cover member **4**). It should be noted, however, that the number of the linear pressure sensing members **31** in the pressure sensing structure **3** is not limited to three, but may be one, two, or four or more. That is, the pressure sensing structure **3** may have at least one linear pressure sensing member **31.**

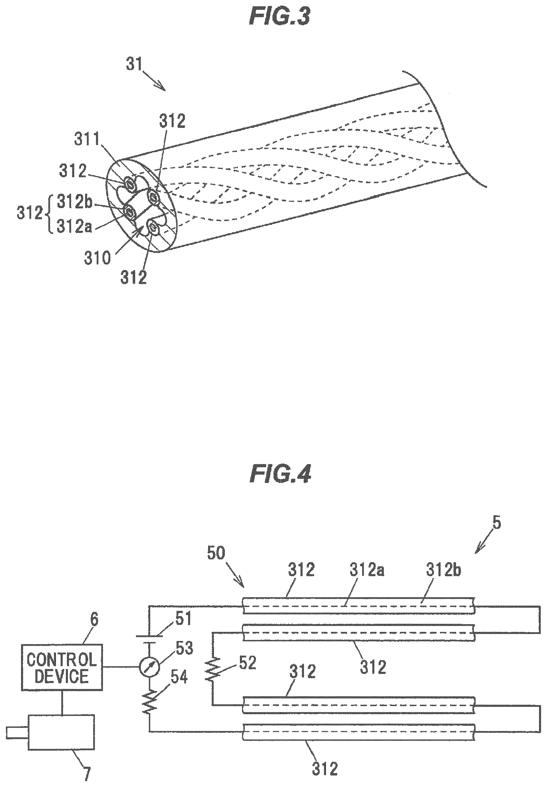

**FIG. 3** is a perspective view showing one linear pressure sensing member **31.** The linear pressure sensing member **31** has a tube **311** which is a tubular elastic body, and a plurality of conductor wires **312** which are arranged to be separated from each other in an inner side of the tube **311.** More specifically, four conductor wires **312** are helically held on the inner surface of the tube **311** while being partially exposed therefrom, and a space **310** having a cross-shaped cross section is formed in a center portion of the tube **311.** Each conductor wire **312** is formed by covering a metal stranded wire **312a** produced by stranding a plurality of metal wires together, with a conductive coating **312b,** for example. The tube **311** is made of a rubber material such as silicone rubber or ethylene propylene rubber, and has an elasticity to be deformed by the exertion of an external force, and restored immediately no external force is exerted. In a natural state in which no external force is exerted to the tube **311,** the plurality of conductor wires **312** are held in such a manner to be non-contact with each other.

In the present embodiment, the coating member **32** covers the three linear pressure sensing members **31** together. When the direction at right angles to the extending direction of the cover member **4** and the moving direction of the slidable door **11** is taken as the width direction of the coating member **32,** the three linear pressure sensing members **31** are equally spaced apart in that width direction. In **FIG 2A****,** this width direction is indicated by an arrow B. The coating member **32** is formed by molding, and is received in the hollow portion **40** of the cover member **4** while being curved in such an arcuate shape that its middle portion in the width direction is protruded forward in the moving direction. That is, the pressure sensing structure **3** is a molded body in which the linear pressure sensing member **31** is molded with the coating member **32,** and in the present embodiment, the three linear pressure sensing members **31** are held together to the coating member **32.**

In the following description, when it is necessary to distinguish each of the three linear pressure sensing members **31** of the pressure sensing structure 3, the pressure sensing member **31** disposed in a middle portion **3a** in the width direction of the pressure sensitive structure **3** will be described as the a first linear pressure sensing member **31A,** and the other two linear pressure sensing members **31** will be described as a second linear pressure sensing member **31B** and a third linear pressure sensing member **31C.** The second and third linear pressure sensing members **31B** and **31C** are arranged in both width direction end portions **3b** and **3c** in both width direction sides, respectively, of the middle portion **3a** in the width direction of the pressure sensing structure **3.**

The cover member **4** integrally includes a base portion **41** fixed to an attachment portion **111** provided in an end portion on the forward side in the moving direction of the slide door **11,** a cover portion **42** provided on the forward side in the moving direction relative to the base portion **41,** to form the hollow portion **40** between it and the base portion **41,** and a protruding portion **43** provided to be protruded from the base portion **41** toward the cover portion **42.** The cover member **4** and the coating member **32** are made of, for example, urethane rubber, EP rubber, silicone rubber, styrene butadiene rubber, chloroprene rubber, olefin based or styrene based thermoplastic elastomer, urethane resin or the like, and they have elasticity to be deformed by pressing force caused by contact with the object to be detected.

The protruding portion **43** faces the middle portion **3a** in the width direction of the pressure sensing structure **3** in the moving direction of the slidable door **11.** In other words, the middle portion **3a** in the width direction of the pressure sensing structure **3** and the protruding portion **43** are aligned in the moving direction of the slidable door **11.** Also, the protruding portion **43** is protruded from the end face **41a** on the forward side in the moving direction of the base portion **41** toward the cover portion **42,** and the cross section shown in **FIG. 2A** (the cross section at right angles to the moving direction of the slidable door **11** and the extending direction of the cover member **4**) is trapezoidal in shape.

Hereinafter, the tip surface in the protruding direction of the protruding portion **43** will be referred to as the top surface **43a,** and the surfaces on both sides thereof will be described as the side surfaces **43b.** The top surface **43a** corresponds to a trapezoidal upper base, and both the side surfaces **43b** correspond to trapezoidal legs. The top surface **43a** and the side surfaces **43b** form an obtuse angle in the cross section shown in **FIG. 2A****.** In the present embodiment, the pressure sensing structure **3** is curved within the hollow portion **40** so as to cover the top surface **43a** of the protruding portion **43** and at least a part of each of the both side surfaces **43b.**

The coating member **32** is not fixed to the cover member **4**, and the movement of the coating member **32** in the hollow portion **40** is regulated by the end portion **321** in the width direction of the coating member **32** being opposed to the inner surface **40a** of the hollow portion **40.** The positions of the first to third linear pressure sensing members **31A** to **31C** in the direction of the arrow B (the width direction of the coating member **32**) within the hollow portion **40** are defined by the coating member **32.** Of the first to third linear pressure sensing members **31A** to **31C,** the first linear pressure sensing member **31A** is positioned at a position corresponding to the front in the moving direction of the top surface **43a** of the protruding portion **43.**

That is, for example, even when the pressure sensing structure **3** is acted on by a force in the moving direction in the width direction of the coating member **32** due to contact with the detection target of the pinching detection switch **2,** the amount of movement of the pressure sensing structure **3** is restricted by the contact between the end portion **321** in the moving direction in the coating member **32** and the inner surface **40a** of the hollow portion **40.** In the present embodiment, the width direction dimension of the coating member **32** is configured so that both the end portions **321** and **321** in the width direction of the coating member **32** abut on the inner surface **40a** of the hollow portion **40.** However, the width direction dimension of the coating member **32** is not limited to this, but may be configured so that when the pressure sensing structure **3** is moved to one side in the width direction of the coating member **32,** the end portion **321** in one side in the width direction of the coating member **32** abuts on the inner surface **40a** of the hollow portion **40,** and when the pressure sensing structure **3** is moved to the other side in the width direction of the coating member **32,** the end portion **321** in the other side in the width direction of the coating member **32** abuts on the inner surface **40a** of the hollow portion **40.**

It should be noted, however, that, as in the present embodiment, when in a normal state where no pinching occurs, both the end portions **321** and **321** in the width direction of the coating member **32** are configured to abut on the inner surface **40a** of the hollow portion **40,** it is possible to more accurately position the first linear pressure sensing member **31A** at a position corresponding to the front in the moving direction of the top surface **43a** of the protruding portion **43,** to thereby be able to improve the detection accuracy of the pinching. Note that the inner surface **40a** of the hollow portion **40** includes the end face **41a** on the forward side in the moving direction of the base portion **41** and the inner surface **42a** of the cover portion **42.**

**FIG 4** is a circuit diagram showing one example of an electric circuit **5** for detecting the pinching in the slidable door **11** with the linear pressure sensing member **31** together with a control device **6** and an electric motor **7** for driving the slidable door **11.** This electric circuit **5** is configured to include the four conductor wires **312** of the linear pressure sensing member **31,** and has a power supply **51,** a resistor **52** for contact detection, which connects together the end portions of two conductor wires **312** of the four conductor wires **312,** an ammeter **53** and a resistor **54** for current limiting, which are connected in series with the power supply **51.** The four conductor wires **312** are connected in series including the resistor **52.** The ammeter **53** is configured to include a current sensor such as a Hall IC and the like and an amplifier, wherein a detection signal thereof is output to the control device **6.**

In the electric circuit **5** configured as described above, when the linear pressure sensing member **31** is pressed to bring the conductor wires **312** into contact with each other, the electric resistance in the line **50** in which the four conductor wires **312** and the resistor **52** are connected in series varies. This change in electrical resistance is detected at the control device **6** as a change in current detected by the ammeter **53,** where it is recognized that the linear pressure sensing member **31** has been pressed. When recognizing that the linear pressure sensing member **31** has been pressed during the closing operation of the slidable door **11,** the control device **6** stops or reverses the electric motor **7.**

Note that in **FIG. 4****,** only the electric circuit **5** corresponding to one linear pressure sensing member **31** is shown, but in the present embodiment, since the pressure sensing structure **3** has the three linear pressure sensing members **31,** the electric circuit **5** is provided to correspond to each of the linear pressure sensing members **31,** and the detection signal of the ammeter **53** of each electric circuit **5** is outputted to the control device **6.** The control device **6** stops or reverses the electric motor **7** when it recognizes that any of the linear pressure sensing members **31** has been pressed.

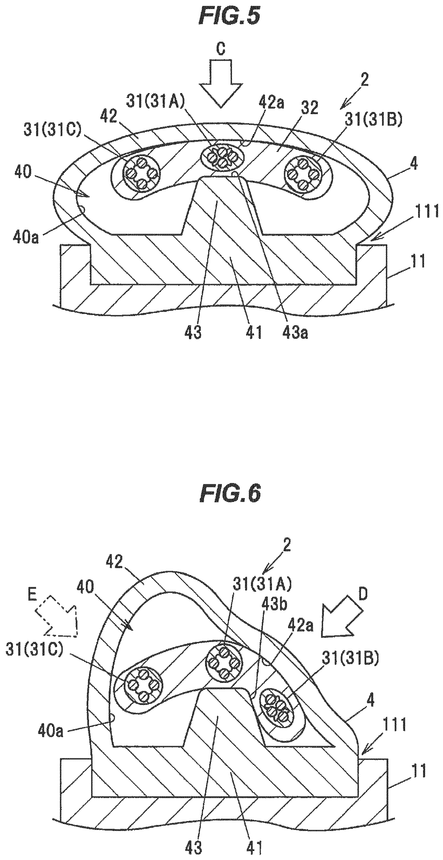

**FIG. 5** is an explanatory view showing a state when the object to be detected comes into contact with the cover member **4** of the pinch detection switch **2** along the moving direction of the slidable door **11.** In **FIG 5****,** the direction of the pressure acting on the pinch detection switch **2** is indicated by an arrow C. In this case, the first linear pressure sensing member **31A** is sandwiched between the top surface **43a** of the protruding portion **43** and the inner surface **42a** of the cover portion **42** so that the conductor wires **312** of the first linear pressure sensing member **31A** are brought into contact (short circuited) with each other. Then, the occurrence of pinching in the slidable door **11** is detected by the first linear pressure sensing member **31**A.

**FIG 6** is an explanatory view showing a state when the object to be detected comes into contact with the cover member **4** along a direction tilted with respect to the moving direction of the slidable door **11.** Such a contact state (a case where the detection as shown in **FIG. 5** is impossible) can occur in a case where, for example, baggage (for example, a corded pass case) of a person outside the vehicle **1** is left behind in the inner side of the slidable door **11,** and that person pulls his baggage from the exterior of the vehicle. In **FIG 6****,** the direction of pressure acting on the pinch detection switch **2** is indicated by an arrow D. In this illustrated example, the second linear pressure sensing member **31B** is sandwiched between the side surface **43b** of the protruding portion **43** and the inner surface **42a** of the cover portion **42,** and the conductor wires **312** are brought into contact (short circuited) with each other. Then, the pinching in the slidable door **11** is detected by the second linear pressure sensing member **31B.**

Note that although not shown, when the object to be detected comes into contact with the cover member **4** along the direction tilted in the direction opposite to the moving direction of the slidable door **11** (the direction of the arrow E indicated by the two-dot chain line in **FIG. 6**), the conductor wires **312** of the third linear pressure sensing member **31C** are brought into contact (short circuited) with each other.

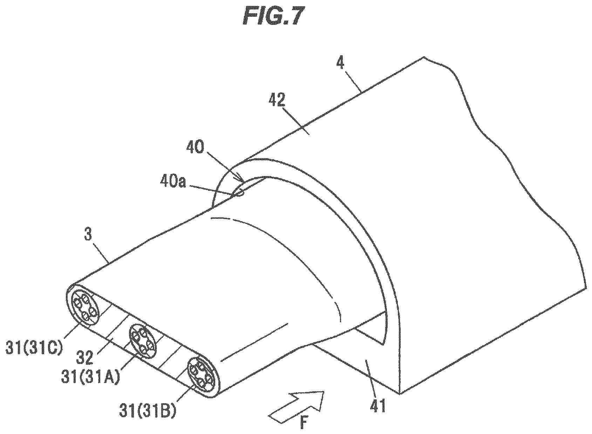

**FIG. 7** is an explanatory view showing an assembling step of inserting the pressure sensing structure **3** into the hollow portion **40** of the cover member **4** at the time of producing the pinch detection switch **2.** In **FIG 7****,** the insertion direction of the pressure sensing structure **3** is indicated by an arrow F.

In the pressure sensing structure **3,** the coating member **32** has a flat plate shape in a natural state before being received in the hollow portion **40** of the cover member **4.** Then, the pressure sensing structure 3 is inserted into the hollow portion **40** with the coating member **32** being elastically deformed to be curved in an arcuate shape. With both the end portions **321** and **321** in the width direction of the coating member **32** being abutted (elastically abutted) on the inner surface **40a** of the hollow portion **40** by the restoring force thereof, and being slid on the inner surface **40a,** the coating member **32** is inserted into the hollow portion **40.** Note that, in order to suppress the sliding resistance in this case, a lubricant may be applied to the surface of the coating member **32** in sliding contact with the inner surface **40a** of the hollow portion **40.**

### (Modifications)

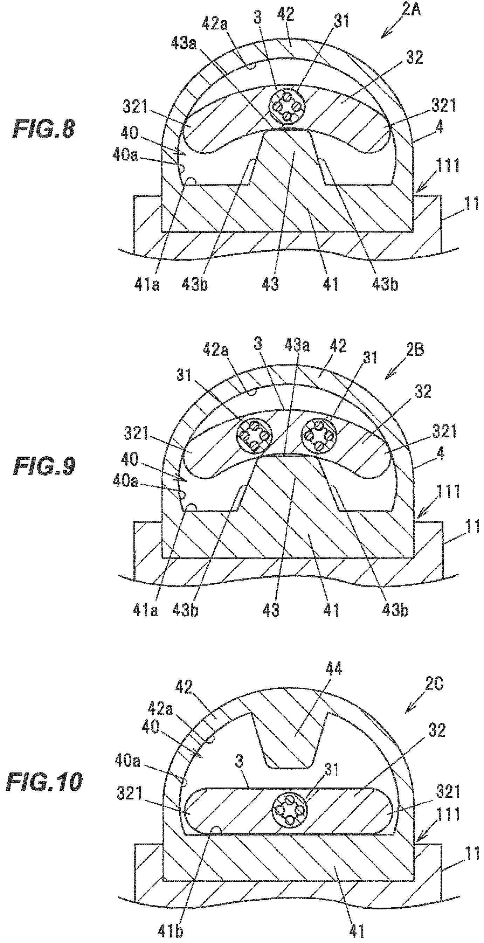

**FIGS. 8** to **10** are cross-sectional views showing pinch detection switches **2**A to **2C** according to modifications to the embodiment. In **FIGS. 8** to **10****,** constituent elements common to those described in the above embodiment are given the same reference numerals as those used in **FIGS. 2A** and the like, and duplicated explanations thereof are omitted.

The first modification shown in **FIG 8** is a modification example when the pressure sensing structure **3** has only one linear pressure sensing member **31.** In this case, the one linear pressure sensing member **31** is disposed on the forward side in the moving direction of the protruding portion **43** of the cover member **4.** In this configuration, as compared with the above embodiment, when the object to be detected comes into contact with the cover member **4** along a direction tilted with respect to the moving direction of the slidable door **11,** the detection precision of the pinching lowers, but the occurrence of pinching in the direction along the moving direction of the slide door **11** which occurs at a highest occurrence frequency can securely be detected.

The second modification shown in **FIG. 9** is a modification example when the pressure sensing structure **3** has two linear pressure sensing members **31.** In this case, the two linear pressure sensing members **31** are arranged on the forward side in the moving direction of a corner between the top face **43a** and both the side faces **43b** of the protruding portion **43** of the cover member **4.** In comparison with the above-described embodiment, this configuration can reduce the number of linear pressure sensing members **31** to reduce the cost, and makes it possible to detect pinching in the direction along the moving direction of the slidable door **11,** and pinching in a direction tilted with respect to the direction of movement of the slidable door **11.**

In the third modified embodiment shown in **FIG. 10****,** the pressure sensing structure **3** has only one linear pressure sensing member **31,** and a protruding portion **44** which is protruded toward that one linear pressure sensing member **31** is provided to be protruded rearward in the moving direction of the slidable door **11** from the cover portion **42** of the cover member **4.** The coating member **32** faces the end face **41a** on the forward side in the moving direction of the base portion **41** while maintaining its flat plate shape, with slight gaps being formed between both the end portions **321** and **321** respectively in the width direction and the inner surface **42a** of the cover portion **42.** The movement of the coating member **32** in the width direction is restricted by these gaps being closed so that either end portion **321** of both the end portions **321** and **321** of the coating member **32** abuts on the inner surface **42a** of the cover portion **42,** which is a part of the inner surface **40a** of the hollow portion **40.** This allows the position of the linear pressure sensing member 31 to be defined to the rear side in the moving direction of the protruding portion **44.**

### (Operation and Advantageous Effects of the Embodiment)

According to the embodiment and its modifications described above, the coating member **32** is interposed between the linear pressure sensing member **31** and the inner surface **40a** of the hollow portion **40** in the cover member **4,** so that the position of the linear pressure sensing member **31** is defined by the coating member **32.** Further, when the pressure sensing structure **3** is inserted into the hollow portion **40** of the cover member **4** during producing of the pinch detection switch **2,** the rigidity of the pressure sensing structure **3** in this insertion direction is ensured by the coating member **32,** and the ratio of the contact area of the outer surface of the coating member **32** in contact with the inner surface **40a** of the hollow portion **40** is limited. Therefore, this work can easily be performed. This makes it easy to assemble, and makes it possible to properly perform pinch detection.

### (Summary of the Embodiment)

Next, the technical ideas grasped from the above-described embodiments will be described with the aid of reference numerals and the like in the embodiments. It should be noted, however, that each of the reference numerals and the like in the following description does not limit the constituent elements in the claims to the members and the like specifically shown in the embodiments.
[1] A pinch detection switch (**2**), comprising:
   a pressure sensing structure (**3**) including at least one linear pressure sensing member (**31**) with a plurality of conductor wires (**312**) spaced apart from each other in an inner side of a tubular elastic body; and
   a tubular cover member (**4**) to be attached to an end portion on a forward side in a moving direction of a movable body (slidable door **11**), the tubular cover member (**4**) being formed with a hollow portion (**40**) which receives the pressure sensing structure (**3**),
   wherein the pressure sensing structure (**3**) includes a coating member (**32**) which covers the at least one linear pressure sensing member (**31**), and which is opposed to an inner surface (**40a**) of the hollow portion (**40**) at both its end portions (**321**, **321**) in a width direction at right angles to the moving direction of the movable body (**11**) and an extending direction of the cover member (**4**),
   wherein a position in the width direction of the at least one linear pressure sensing member (**31**) in the hollow portion (**40**) is defined by the coating member (**32**).
[2] The pinch detection switch (**2**) according to [1] above, wherein the at least one linear pressure sensing member (**31**) is disposed in a middle portion (**3a**) in the width direction of the pressure sensing structure (**3**),
   wherein the cover member (**4**) includes a protruding portion (**43**/**44**) which faces the middle portion (**3a**) of the pressure sensing structure (**3**) in the moving direction of the movable body (**11**).
[3] The pinch detection switch (**2**) according to [2] above, wherein the pressure sensing structure (**3**) includes three of the linear pressure sensing members (**31**), and one (**31A**) of the three linear pressure sensing members (**31**) is disposed in the middle portion (**3a**) and other two (**31B**, **31C**) of the three linear pressure sensing members (**31**) are disposed in both sides, respectively, in the width direction of the middle portion (**3a**).
[4] The pinch detection switch (**2**) according to [3] above, wherein the cover member (**4**) includes a base portion (**41**) to be fixed to the movable body (**11**), and a cover portion (**42**) to be provided on the forward side in the moving direction of the movable body (**11**) relative to the base portion (**41**), to form the hollow portion (**40**) between it and the base portion (**41**),
   wherein the protruding portion (**43**) is provided to protrude from the base portion (**41**) toward the cover portion (**42**),
   wherein when a pinched object to be detected comes in contact with the cover member (**4**) along the moving direction of the movable body (**11**), the linear pressure sensing member (**31A**) disposed in the middle portion (**3a**) is sandwiched between a top surface (**43a**) of the protruding portion (**43**) and an inner surface (**42a**) of the cover portion (**42**),
   wherein when the pinched object to be detected comes into contact with the cover member (**4**) along a direction tilted with respect to the moving direction of the movable body (**11**), either one (**31B**, **31C**) of the two linear pressure sensing members (**31B**, **31C**) disposed in both the sides in the width direction of the middle portion (**3a**) the linear pressure sensing members (**31**) is sandwiched between a side surface (**43a**) of the protruding portion (**43**) and the inner surface (**42a**) of the cover portion (**42**).
[5] The pinch detection switch (**2**) according to [4] above, wherein the pressure sensing structure (**3**) is curved so as to at least partially cover the top surface (**43a**) and the side surface (**43b**) of the protruding portion (**43**) within the hollow portion (**40**).
[**6**] The pinch detection switch (**2**) according to any one of [**1**] to [**5**] above, wherein both the end portions (**321**, **321**) of the coating member (**32**) of the pressure sensing structure (**3**) abut on the inner surface (**40a**) of the hollow portion (**40**) in a normal state in which no pinching occurs.
[**7**] The pinch detection switch (**2**) according to any one of [**1**] to [**6**] above, wherein the pressure sensing structure (**3**) is a molded body in which the at least one linear pressure sensing member (**31**) is molded with the coating member (**32**).

Although the embodiment of the present invention has been described above, the embodiment described above does not limit the invention according to the claims. It should also be noted that not all combinations of the features described in the embodiments are indispensable to the means for solving the problem of the invention.

Further, the present invention can appropriately be modified and carried out within the scope not deviating from the spirit thereof. For example, although in the above-described embodiment, there has been described the case in which the coating member **32** is in a flat plate shape in the natural state before being received in the hollow portion **40** of the cover member **4**, the coating member **32** may be molded into a curved shape. Further, the shape of the coating member **32** in the natural state is not limited to a flat plate shape, but may be, for example, a U shape or a V shape which is protruded toward the forward side in the moving direction or the rear side in the moving direction.

Also, with respect to the pressure sensing structure (**3**), one or more linear pressure sensing members (**31**) may be structured to be arranged side by side on the adhesive surface side of a wide tape and then sandwiched between that tape and another wide tape. That is, it is a pressure sensing structure with a single or a plurality of linear pressure sensing members (**31**) arranged between two tapes. In this case, the outer surface shape of the pressure sensing structure is not an elliptical shape in a cross section view as shown in **FIG. 7**, but only a portion of the linear pressure sensing member (**31**) is in a protruding shape, and when a plurality of the linear pressure sensing members (**31**) are arranged, a pressure sensing structure having a wavy outer surface shape is produced.

With this structure, as the pressure sensing structure, in a cross section view, a thick portion in which the linear pressure sensing member is disposed and a non-thick portion in which no linear pressure sensing member is disposed are formed, but this non-thick portion, in other words, the portion where the thickness of the pressure sensing structure is thin is a portion which is easily deformed. That is, this ease of deformation contributes to ease of producing the pinch detection switch.

Further, with respect to the pressure sensing structure (**3**) having a plurality of the linear pressure sensing members (**31**), the coating member (**32**) between the linear pressure sensing members may be provided with a cut (a groove) along the linear pressure sensing members. With this configuration, as the pressure sensing structure, in a cross-sectional view, thick portions where the linear pressure sensing members are disposed and non-thick portions between the linear pressure sensing members are formed, but this non-thick portion, in other words, the portion where the thickness of the pressure sensing structure is thin is a portion which is easily deformed. That is, this ease of deformation contributes to ease of producing the pinch detection switch.

Although the invention has been described with respect to the specific embodiments for complete and clear disclosure, the appended claims are not to be thus limited but are to be construed as embodying all modifications and alternative constructions that may occur to one skilled in the art which fairly fall within the basic teaching herein set forth.

## Claims

1. A pinch detection switch (2), comprising:
a pressure sensing structure (3) including at least one linear pressure sensing member (31) with a plurality of conductor wires (312) spaced apart from each other in an inner side of a tubular elastic body; and
a tubular cover member (4) to be attached to an end portion on a forward side in a moving direction of a movable body (11), the tubular cover member (4) being formed with a hollow portion (40) which receives the pressure sensing structure (3),
wherein the pressure sensing structure (3) includes a coating member (32) which covers the at least one linear pressure sensing member (31), and which is opposed to an inner surface of the hollow portion (40) at both its end portions in a width direction at right angles to the moving direction of the movable body (11) and an extending direction of the cover member (4),
wherein a position in the width direction of the at least one linear pressure sensing member (31) in the hollow portion (40) is defined by the coating member, **characterized in that**
the at least one linear pressure sensing member (31) is disposed in a middle portion in the width direction of the pressure sensing structure (3),
wherein the cover member (4) includes a protruding portion (43) which faces the middle portion of the pressure sensing structure (31) in the moving direction of the movable body (11).

2. The pinch detection switch (2) according to claim 1, wherein the pressure sensing structure (3) includes three of the linear pressure sensing members (31), and one of the three linear pressure sensing members (31) is disposed in the middle portion and other two of the three linear pressure sensing members are disposed in both sides, respectively, in the width direction of the middle portion.

3. The pinch detection switch (2) according to claim 2, wherein the cover member (4) includes a base portion (41) to be fixed to the movable body (11), and a cover portion (42) to be provided on the forward side in the moving direction of the movable body (11) relative to the base portion (41), to form the hollow portion (40) between it and the base portion (41),
wherein the protruding portion (43) is provided to protrude from the base portion toward the cover portion (42),
wherein when a pinched object to be detected comes in contact with the cover member (4) along the moving direction of the movable body (11), the linear pressure sensing member disposed in the middle portion is sandwiched between a top surface of the protruding portion and an inner surface of the cover portion,
wherein when the pinched object to be detected comes into contact with the cover member (4) along a direction tilted with respect to the moving direction of the movable body (11), either one of the two linear pressure sensing members (31) disposed in both the sides in the width direction of the middle portion the linear pressure sensing members is sandwiched between a side surface of the protruding portion (43) and the inner surface of the cover portion (42).

4. The pinch detection switch (2) according to claim 3, wherein the pressure sensing structure (3) is curved so as to at least partially cover the top surface and the side surface of the protruding portion (43) within the hollow portion (40).

5. The pinch detection switch (2) according to any one of claims **1** to **4,** wherein both the end portions of the coating member of the pressure sensing structure (3) abut on the inner surface of the hollow portion (40) in a normal state in which no pinching occurs.

6. The pinch detection switch (2) according to any one of claims **1** to 5, wherein the pressure sensing structure (3) is a molded body in which the at least one linear pressure sensing member (31) is molded with the coating member.

## Patentansprüche

1. Ein Einklemmungserkennungsschalter (2), umfassend:
eine Drucksensorstruktur (3) mit mindestens einem linearen Drucksensorelement (31) mit einer Vielzahl von Leiterdrähten (312), die in einer Innenseite eines rohrförmigen elastischen Körpers voneinander beabstandet sind; und
ein röhrenförmiges Abdeckelement (4), das an einem Endabschnitt auf einer Vorderseite in einer Bewegungsrichtung eines beweglichen Körpers (11) anzubringen ist, wobei das röhrenförmige Abdeckelement (4) mit einem hohlen Abschnitt (40) ausgebildet ist, der die Drucksensorstruktur (3) aufnimmt,
wobei die Drucksensorstruktur (3) ein Beschichtungselement (32) enthält, das das mindestens eine lineare Drucksensorelement (31) bedeckt und das einer Innenfläche des hohlen Abschnitts (40) an seinen beiden Endabschnitten in einer Breitenrichtung rechtwinklig zur Bewegungsrichtung des beweglichen Körpers (11) und einer Erstreckungsrichtung des Abdeckelements (4) gegenüberliegt,
wobei eine Position in der Breitenrichtung des mindestens einen linearen Drucksensorelements (31) in dem hohlen Abschnitt (40) durch das Beschichtungselement definiert ist, **dadurch gekennzeichnet, dass**
das mindestens eine lineare Drucksensorelement (31) in einem mittleren Abschnitt in der Breitenrichtung der Drucksensorstruktur (3) angeordnet ist,
wobei das Abdeckelement (4) einen vorspringenden Abschnitt (43) aufweist, der dem mittleren Abschnitt der Drucksensorstruktur (31) in der Bewegungsrichtung des beweglichen Körpers (11) gegenüberliegt.

2. Einklemmungserkennungsschalter (2) nach Anspruch 1, wobei die Drucksensorstruktur (3) drei der linearen Drucksensorelemente (31) umfasst und eines der drei linearen Drucksensorelemente (31) in dem mittleren Abschnitt angeordnet ist und die anderen zwei der drei linearen Drucksensorelemente jeweils auf beiden Seiten in der Breitenrichtung des mittleren Abschnitts angeordnet sind.

3. Einklemmungserkennungsschalter (2) nach Anspruch 2, wobei das Abdeckungselement (4) einen Basisabschnitt (41), der an dem beweglichen Körper (11) zu befestigen ist, und einen Abdeckungsabschnitt (42) aufweist, der auf der in Bewegungsrichtung des beweglichen Körpers (11) vorderen Seite relativ zu dem Basisabschnitt (41) vorzusehen ist, um den hohlen Abschnitt (40) zwischen ihm und dem Basisabschnitt (41) zu bilden,
wobei der vorstehende Abschnitt (43) vorgesehen ist, um von dem Basisabschnitt in Richtung des Abdeckabschnitts (42) vorzustehen,
wobei, wenn ein zu erfassendes eingeklemmtes Objekt mit dem Abdeckelement (4) entlang der Bewegungsrichtung des beweglichen Körpers (11) in Kontakt kommt, das in dem mittleren Abschnitt angeordnete lineare Drucksensorelement zwischen einer oberen Oberfläche des vorstehenden Abschnitts und einer inneren Oberfläche des Abdeckabschnitts eingeklemmt wird,
wobei, wenn das eingeklemmte, zu erfassende Objekt mit dem Abdeckelement (4) entlang einer Richtung in Kontakt kommt, die in Bezug auf die Bewegungsrichtung des beweglichen Körpers (11) geneigt ist, eines der beiden linearen Drucksensorelemente (31), die an den beiden Seiten in der Breitenrichtung des mittleren Abschnitts angeordnet sind, zwischen einer Seitenfläche des vorstehenden Abschnitts (43) und der Innenfläche des Abdeckungsabschnitts (42) eingeschlossen ist.

4. Einklemmungserkennungsschalter (2) nach Anspruch 3, wobei die Drucksensorstruktur (3) so gekrümmt ist, dass sie zumindest teilweise die obere Fläche und die Seitenfläche des vorstehenden Abschnitts (43) innerhalb des hohlen Abschnitts (40) abdeckt.

5. Einklemmungserkennungsschalter (2) nach einem der Ansprüche 1 bis 4, wobei die beiden Endabschnitte des Beschichtungselements der Drucksensorstruktur (3) in einem normalen Zustand, in dem keine Einklemmung auftritt, an der Innenfläche des hohlen Abschnitts (40) anliegen.

6. Einklemmungserkennungsschalter (2) nach einem der Ansprüche 1 bis 5, wobei die Drucksensorstruktur (3) ein Formkörper ist, in dem das mindestens eine lineare Drucksensorelement (31) mit dem Beschichtungselement vergossen ist.

## Revendications

1. Un commutateur (2) de détection de pincement, comprenant :
une structure (3) de détection de pression comprenant au moins un élément (31) de détection de pression linéaire avec une pluralité de fils conducteurs (312) espacés les uns des autres dans un côté intérieur d'un corps élastique tubulaire ; et
un élément de recouvrement (4) tubulaire destiné à être fixé à une partie d'extrémité sur un côté avant dans une direction de déplacement d'un corps mobile (11), l'élément de recouvrement (4) tubulaire étant formé avec une partie creuse (40) qui reçoit la structure (3) de détection de pression,
la structure (3) de détection de pression comprenant un élément de revêtement (32) qui recouvre ledit au moins un élément (31) de détection de pression linéaire, et qui est opposé à une surface intérieure de la partie creuse (40) à ses deux parties d'extrémité dans une direction de largeur perpendiculaire à la direction de déplacement du corps mobile (11) et à une direction d'extension de l'élément de recouvrement (4),
une position dans la direction de la largeur dudit au moins un élément (31) de détection de pression linéaire dans la partie creuse (40) étant définie par l'élément de revêtement, **caractérisé en ce que**
ledit au moins un élément (31) de détection de pression linéaire est disposé dans une partie médiane dans la direction de la largeur de la structure (3) de détection de pression,
l'élément de recouvrement (4) comprenant une partie en saillie (43) qui est tournée vers la partie médiane de la structure (31) de détection de pression dans la direction de déplacement du corps mobile (11).

2. Le commutateur (2) de détection de pincement selon la revendication 1, dans lequel la structure (3) de détection de pression comprend trois des éléments (31) de détection de pression linéaire, et l'un des trois éléments (31) de détection de pression linéaire est disposé dans la partie médiane et les deux autres des trois éléments de détection de pression linéaires sont disposés respectivement des deux côtés dans la direction de la largeur de la partie médiane.

3. Le commutateur (2) de détection de pincement selon la revendication 2, dans lequel l'élément de recouvrement (4) comprend une partie de base (41) destinée à être fixée au corps mobile (11), et une partie de recouvrement (42) destinée à être présente sur le côté avant dans la direction de déplacement du corps mobile (11) par rapport à la partie de base (41), pour former la partie creuse (40) entre elle et la partie de base (41),
la partie en saillie (43) étant prévue pour faire saillie de la partie de base vers la partie de recouvrement (42) ;
lorsqu'un objet pincé destiné à être détecté entre en contact avec l'élément de recouvrement (4) selon la direction de déplacement du corps mobile (11), l'élément de détection de pression linéaire disposé dans la partie médiane est pris en sandwich entre une surface supérieure de la partie en saillie et une surface intérieure de la partie de recouvrement ;
lorsque l'objet pincé destiné à être détecté entre en contact avec l'élément de recouvrement (4) le long d'une direction inclinée par rapport à la direction de déplacement du corps mobile (11), l'un ou l'autre des deux éléments (31) de détection de pression linéaire disposé dans les deux côtés dans la direction de la largeur de la partie médiane des éléments de détection de pression linéaire est pris en sandwich entre une surface latérale de la partie en saillie (43) et la surface intérieure de la partie de recouvrement (42).

4. Le commutateur (2) de détection de pincement selon la revendication 3, dans lequel la structure (3) de détection de pression est incurvée de manière à recouvrir au moins partiellement la surface supérieure et la surface latérale de la partie en saillie (43) à l'intérieur de la partie creuse (40).

5. Le commutateur (2) de détection de pincement selon l'une quelconque des revendications 1 à 4, dans lequel les deux parties d'extrémité de l'élément de revêtement de la structure (3) de détection de pression butent sur la surface intérieure de la partie creuse (40) dans un état normal dans lequel aucun pincement ne se produit.

6. Le commutateur (2) de détection de pincement selon l'une quelconque des revendications 1 à 5, dans lequel la structure (3) de détection de pression est un corps moulé dans lequel ledit au moins un élément (31) de détection de pression linéaire est moulé avec l'élément de revêtement.
